# EUROPÄISCHE PATENTSCHRIFT

(11) **EP 0 909 480 B1**
(45) Veröffentlichungstag und Bekanntmachung des Hinweises auf die Patenterteilung: **01.03.2000**
(21) Anmeldenummer: 97931637.9
(22) Anmeldetag: 23.06.1997
(51) Int. Cl.: H03H 9/02

(54) **SUBSTRAT FÜR MIT AKUSTISCHEN OBERFLÄCHENWELLEN ARBEITENDE BAUELEMENTE**
SUBSTRATE FOR SURFACE ACOUSTIC WAVE DEVICES
SUBSTRAT POUR COMPOSANTS FONCTIONNANT AVEC DES ONDES DE SURFACE ACOUSTIQUES

(30) Priorität: 01.07.1996 DE 19626410
(43) Veröffentlichungstag der Anmeldung: 21.04.1999
(73) Patentinhaber: SIEMENS MATSUSHITA COMPONENTS GmbH & CO. KG, 81541 München (DE)
(72) Erfinder: PAHL, Wolfgang, D-80336 München (DE)
(74) Vertreter: Zedlitz, Peter
(86) Internationale Anmeldenummer: DE9701294
(87) Internationale Veröffentlichungsnummer: WO9800913

(56) Entgegenhaltungen:
- FR-A- 2 370 387
- GB-A- 2 073 528
- PATENT ABSTRACTS OF JAPAN vol. 011, no. 017 (E-471), 17.Januar 1987 & JP 61 187412 A (MURATA MFG CO LTD), 21.August 1986,

## Beschreibung

Die vorliegende Erfindung betrifft ein Substrat für mit akustischen Oberflächenwellen arbeitende Bauelemente - OFW-Bauelemente - nach dem Oberbegriff des Patentanspruchs 1.

In der älteren deutschen Patentanmeldung 1 954 8043.0 ist bereits beschrieben worden, in Substraten von OFW-Bauelementen an der Oberflächenseite, welche der eine akustische Oberflächenwelle führenden Oberflächenseite abgewandt ist, Schlitze zur Dämpfung von akustischen Störwellen - Volumenwellen - vorzusehen. Dadurch entstehen auf der bearbeiteden, Schlitze enthaltenden Oberflächenseite Bereiche, an denen Volumenwellen gestreut werden, so daß - wenn überhaupt - nur noch ein vernachlässigbarer Bruchteil dieser Volumenwellen in den die akustische Oberflächenwelle führenden Bereich gelangt.

Diese deutsche Patentanmeldung ist erst nach dem Prioritätsdatum der vorliegenden Anmeldung veroffentlicht. In dieser deutschen Patentanmeldung ist weiterhin ausgeführt, daß Schlitze der genannten Art durch Einsägen oder Strahlbearbeitung durch Strahlmasken hergestellt werden können. Durch Sägen erzeugte Schlitze sind naturgemäß auf geradlinige nicht unterbrochene Muster beschränkt. Durch die Geradlinigkeit kommt es aus praktischen Gründen in der Regel zu einer Parallelität der Schlitze, was nicht optimal für das Streuvermögen von Volumenwellen ist. Verlaufen geradlinige Schlitze quer zur Ausbreitungsrichtung von akustischen Oberflächenwellen im Substrat, so kann die Bruchfestigkeit insbesondere bei niederfrequenten Bauelementen nicht befriedigend sein, weil üblicherweise die größte geometrische Ausdehnung des Substrats in Ausbreitungsrichtung einer akustischen Oberflächenwelle vorhanden und das Sägemuster dazu quer orientiert ist.

Bei dem in der oben genannten älteren deutschen Patentanmeldung angegebenen Verfahren zur Herstellung von Schlitzen durch Strahlbearbeitung werden ebenfalls nur geradlinig verlaufende Schlitze in Betracht gezogen.

Das Dokument GB-A-2 073 528 zeigt ein OWF Bauelement mit Rillen, die in ihrer Tiefe und in ihrem Abstand zueinander variiert sind. Sie sind schräg zur Ausbereitungsrichtung angebracht.

Der vorliegenden Erfindung liegt die Aufgabe zugrunde, Schlitzformen anzugeben, mit denen sowohl mechanische als auch akustische Eigenschaften von Substraten für OFW-Bauelemente günstiger berücksichtigt werden können.

Diese Aufgabe wird bei einem Substrat für mit akustischen Oberflächenwellen arbeitende Bauelemente der eingangs genannten Art durch die Maßnahme des kennzeichnenden Teils des Patentanspruchs 1 gelöst.

Weiterbildungen der Erfindung sind Gegenstand von Unteransprüchen.

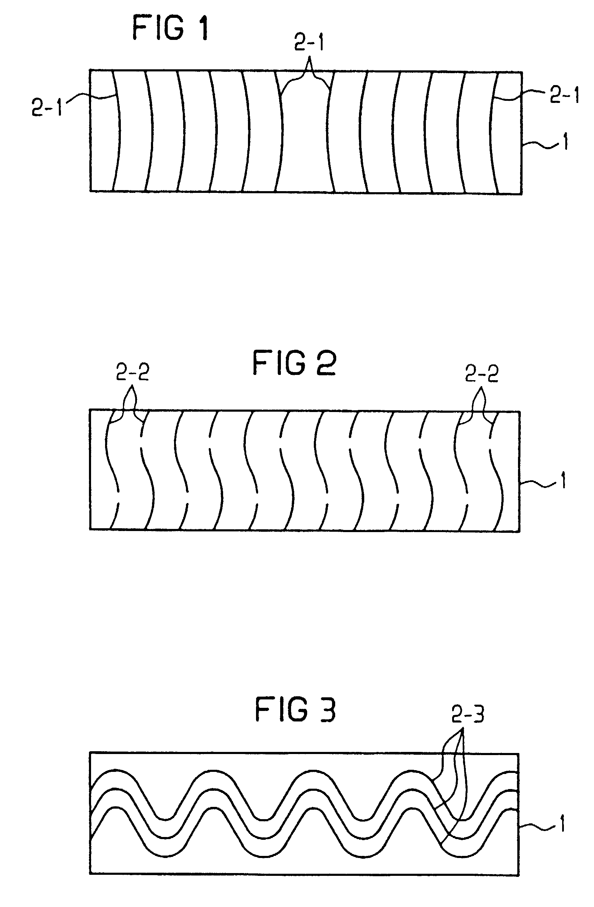

Die Erfindung wird nachfolgend anhand von in den Figuren der Zeichnungen dargestellten Ausführungsbeispielen näher erläutert. Darin zeigen die Figuren 1 bis 6 Substrate mit unterschiedlichen Ausführungsformen von schlitzförmigen Vertiefungen zur Unterdrückung von akustischen Volumenwellen.

Bei der Ausführungsform nach Figur 1 sind an einer Seite eines Substrats 1 Schlitze 2-1 vorgesehen, welche in einer Richtung quer zu einer im Substrat 1 verlaufenden akustischen Oberflächenwelle gekrümmt ausgebildet sind. Insbesondere laufen dabei nicht alle Schlitze 2-1 parallel.

Figur 2 zeigt eine der Figur 1 entsprechende Ausführungsform von Schlitzen 2-2, die jedoch im Gegensatz zu den Schlitzen 2-1 nach Figur 2 unterbrochen sind.

Figur 3 zeigt eine Ausführungsform von wellenförmigen in Ausbreitungsrichtung einer akustischen Oberflächenwelle verlaufenden Schlitzen 2-3. Dabei ist insbesondere vorgesehen, daß sich deren Einhüllende in Richtung quer zur Ausbreitungsrichtung einer akustischen Qberflächenwelle überlappen.

Die Figuren 4 und 5 zeigen gezackte Schlitze 2-4 bzw. 2-5, wobei die Schlitze 2-4 nach Figur 4 quer zur Ausbreitungsrichtung einer akustischen Oberflächenwelle und die Schlitze 2-5 in Richtung einer akustischen Oberflächenwelle verlaufen.

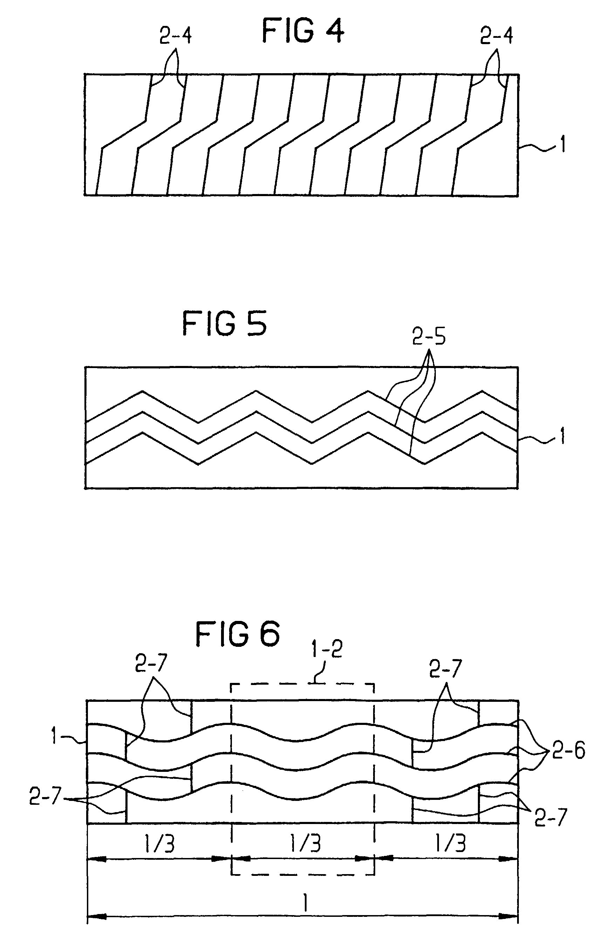

Im Hinblick auf die mechanische Festigkeit des Substrats ist es insbesondere zweckmäßig, wenn in Weiterbildung der Erfindung zwischen Schlitzen bzw. Vertiefungen in einem mittleren Substratbereich eine unreduzierte Materialstärke vorhanden ist. Eine derartige Ausführungsform ist in Figur 6 dargestellt. In einem Substrat 1 der Länge 1 sind geschlitzte wellenförmig verlaufende Vertiefungen 2-6 vorgesehen, wobei in einem mittleren gestrichelt eingefaßten Bereich 1-2 des Substrates 1 zwischen den schlitzförmigen Vertiefungen 2-6 eine unreduzierte Materialstärke vorhanden ist. Dieser mittlere Bereich ist mindestens gleich einem Drittel 1/3 der Gesamtlänge 1 des Substrates 1. Außerhalb dieses mittleren Bereiches 1-2 können auch weitere hier in Querrichtung verlaufende Schlitze 2-7 vorgesehen sein, so daß zwischen den Schlitzen 2-6 eine stellenweise reduzierte Materialstärke vorhanden ist.

Erfindungsgemäß wird es in besonders einfacher Weise und mit großer Freiheit möglich, beliebig gekrümmte, gezackte, nicht parallele, unterbrochene oder durchgehende Schlitzformen zu erzeugen. Dabei ergeben sich die folgenden Vorteile:
- Gegen Bruchneigung wirken gekrümmte unterbrochene Muster;
- die Streu- und Dämpfungseigenschaften von Volumenwellen werden durch nichtparallele gekrümmte oder gezackte Strukturen begünstigt;
- verlaufen Schlitze zu mindestens einem Substratrand, wie dies in den Figuren 1 bis 6 dargestellt ist, so werden Probleme vermieden, welche sich beim Aufkleben des Substrats auf einem Systemträger ergeben können, weil beim Aufsetzen des Substrats mit der die Schlitze enthaltenden Oberflächenseite auf das Kleberbett Lufteinschlüsse aus den Schlitzen entweichen können.

## Patentansprüche

1. Substrat (1) für mit akustischen Oberflächenwellen arbeitende Bauelemente - OFW-Bauelemente - , bei dem an der Oberflächenseite, welche der eine akustische Oberflächenwelle führenden Oberflächenseite abgewandt ist, zur Unterdrückung von akustischen Volumenwellen ein Muster aus gekrümmten oder gezackten schlitzförmigen Vertiefungen (2-1,...2-6) vorgesehen ist.

2. Substrat (1) nach Anspruch 1,
bei dem die Vertiefungen (2-1,...,2-6) nicht parallel verlaufen.

3. Substrat (1) nach Anspruch 1 und/oder 2,
bei dem die Vertiefungen (2-1,...,2-6) mindestens eine Verbindung zu einem Substratrand aufweisen.

4. Substrat (1) nach einem der Ansprüche 1 bis 3,
bei dem die Vertiefungen (2-1;2-2;2-4) quer zur Ausbreitungsrichtung einer akustischen Oberflächenwelle verlaufen.

5. Substrat (1) nach einem der Ansprüche 1 bis 5,
bei dem die Vertiefungen (2-3;2-5;2-6) in Ausbreitungsrichtung einer akustischen Oberflächenwelle verlaufen.

6. Substrat (1) nach einem der Ansprüche 1 bis 5,
bei dem die Vertiefungen (2-2) unterbrochen sind.

7. Substrat (1) nach einem der Ansprüche 1 bis 6,
bei dem in Ausbreitungsrichtung einer akustischen Oberfläche in einem mittleren Substratbereiche (1-2) zwischen Vertiefungen (2-6) eine unreduzierte Materialstärke vorhanden ist.

8. Substrat (1) nach Anspruch 7,
bei dem der mittlere Substratbereich (1-2) eine Länge von wenigstens einem Drittel der Substratgesamtlänge (1) besitzt.

9. Substrat (1) nach Anspruch 1
bei dem in Ausbreitungsrichtung einer akustischen Oberflächenwelle verlaufende wellenförmige Vertiefungen (2-3) vorgesehen sind, deren Einhüllende sich in Richtung quer zur Ausbreitungsrichtung einer akustischen Oberflächenwelle überlappen.

## Claims

1. Substrate (1) for components which operate with surface acoustic waves - SAW components -, in which a pattern composed of curved or jagged depressions (2-1, ..., 2-6) in the form of slots is provided to suppress acoustic volume waves on that surface side which faces away from the surface side which carries a surface acoustic wave.

2. Substrate (1) according to Claim 1, in which the depressions (2-1, ..., 2-6) do not run parallel.

3. Substrate (1) according to Claim 1 and/or 2, in which the depressions (2-1, ..., 2-6) have at least one connection forming a substrate edge.

4. Substrate (1) according to one of Claims 1 to 3, in which the depressions (2-1; 2-2; 2-4) run transversely with respect to the propagation direction of the surface acoustic wave.

5. Substrate (1) according to one of Claims 1 to 5, in which the depressions (2-3; 2-5; 2-6) run in the propagation direction of a surface acoustic wave.

6. Substrate (1) according to one of Claims 1 to 5, in which the depressions (2-2) are interrupted.

7. Substrate (1) according to one of Claims 1 to 6, in which an unreduced material thickness is provided between depressions (2-6) in the propagation direction of an acoustic surface in a central substrate area (1-2).

8. Substrate (1) according to Claim 7, in which the central substrate area (1-2) has a length of at least one third of the total substrate length (1).

9. Substrate (1) according to Claim 1, in which depressions (2-3) which run in the propagation direction of a surface acoustic wave and are in the form of waves are provided, whose envelopes overlap in the direction transversely with respect to the propagation direction of the surface acoustic wave.

## Revendications

1. Substrat (1) pour des composants travaillant par des ondes acoustiques de surface - composants OAS -, dans lequel il est prévu sur la face supérieure, qui est éloignée de la face guidant une onde acoustique de surface, un tracé de renfoncement (2-1, ..., 2-6) en forme de fente incurvée ou en zig-zag pour supprimer des ondes de volume acoustiques.

2. Substrat (1) suivant la revendication 1, dans lequel les renfoncements (2-1, ..., 2-6) ne s'étendent pas parallèlement.

3. Substrat (1) suivant la revendication 1 et/ou 2, dans lequel les renfoncements (2-1, ..., 2-6) comportent au moins une liaison avec un bord du substrat.

4. Substrat (1) suivant l'une des revendications 1 à 3, dans lequel les renfoncements (2-1 ; 2-2 ; 2-4) s'étendent transversalement à la direction de propagation d'une onde acoustique de surface.

5. Substrat (1) suivant l'une des revendications 1 à 5, dans lequel les renfoncements (2-3 ; 2-5 ; 2-6) s'étendent dans la direction de propagation d'une onde acoustique de surface.

6. Substrat (1) suivant l'une des revendications 1 à 5, dans lequel les renfoncements (2-2) sont interrompus.

7. Substrat (1) suivant l'une des revendications 1 à 6, dans lequel il est présent dans la direction de propagation d'une onde acoustique de surface une épaisseur de matériau non réduite dans une région (1-2) de substrat centrale entre des renfoncements (2-6).

8. Substrat (1) suivant la revendication 7, dans lequel la région (1-2) de substrat centrale a une longueur d'au moins un tiers de la longueur (I) de tout le substrat.

9. Substrat (1) suivant la revendication 1, dans lequel il est prévu des renfoncements (2-3) ondulés, qui s'étendent dans la direction de propagation d'une onde acoustique de surface et dont les enveloppes se chevauchent dans la direction s'étendant transversalement à la direction de propagation d'une onde acoustique de surface.
